# EUROPEAN PATENT APPLICATION

(11) **EP 0 599 327 A1**
(43) Date of publication of application: **01.06.1994**
(21) Application number: 93119045.8
(22) Date of filing: 25.11.1993
(51) Int. Cl.: H03F 1/02

(54) **Variable gain amplifier**

(30) Priority: 25.11.1992 JP 338129/92
(71) Applicant: NEC CORPORATION, Tokyo (JP)
(72) Inventor: Asazawa, Hiroshi, c/o NEC Corporation, Minato-ku, Tokyo (JP)
(74) Representative: Betten & Resch

(57) **Abstract**

Disclosed is a variable gain amplifier. A variable current source (6) is provided between the base of an emitter-grounded transistor (1) and the ground, so that the distribution of the base bias current of the transistor (1) is controlled by controlling a change in the current of the variable current source (6), thereby controlling the amplifier gain. As the emitter of the transistor (1) can be directly grounded, thus eliminating the need for a bypass capacitor and facilitating integration of the amplifier. As the base current of the transistor (1) is controlled, the control power can be made very low. Further, a single stage of a transistor (61) is provided between the power source and the ground, the voltage of the power source can be reduced further. It is therefore possible to provide a variable gain amplifier, which accomplishes low power consumption, is operable on a low voltage, is easy to be integrated, and is suitable for use as a high-frequency power amplifier of 1 to 2 GHz in a battery-driven portable electronic device, such as a mobile telephone.

## Description

The present invention relates to a variable gain amplifier, and, more particularly, to an emitter-grounded type variable gain amplifier for high-frequency amplification.

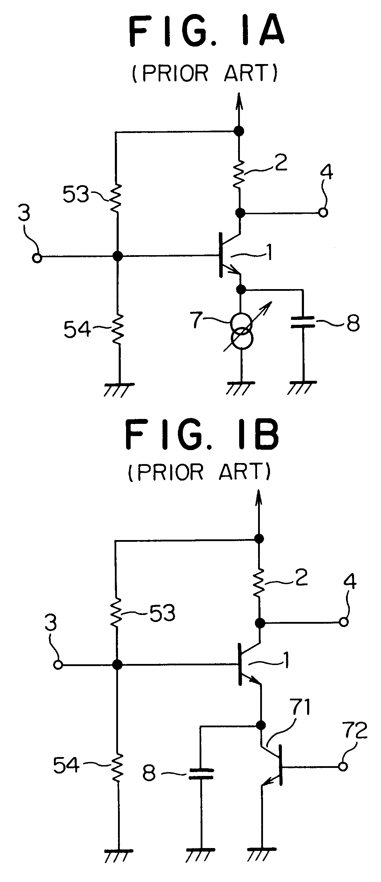

Figs. 1A and 1B illustrate a conventional variable gain amplifier of this type. Fig. 1A presents the conceptual diagram of this amplifier, and Fig. 1B a circuit diagram showing a specific example of the amplifier. An amplifying transistor 1, which functions as an emitter-grounded type, has its collector connected to an output terminal 4 from which an amplified output is to be output. An input terminal 3 is connected to the base of the transistor 1 so that an input to be amplified (hereinafter referred to as "amplification input") is supplied to this base. A collector load resistor 2 is connected between the collector of the transistor 1 and a circuit power source. A fixed-bias resistor 53 is connected between the base of the transistor 1 and the power source, and a fixed-bias resistor 54 between the base of the transistor 1 and the ground.

A variable current source 7 is provided between the emitter of the transistor 1 and the ground to control the gain of this amplifier. A capacitor 8 is provided in parallel to this variable current source 7 for the AC bypass of this variable current source 7 to allow the amplifying transistor 1 to function as an emitter-grounded type. More specifically, this current source 7 comprises a current-source transistor 71 having its base supplied via a terminal 72 with a variable-controlled voltage, as shown in Fig. 1B. This transistor 71 is inserted between the emitter of the amplifying transistor 1 and the ground.

With the above structure, the current value of the transistor 71 varies in accordance with the voltage of the variable-controlled voltage terminal 72. As a result, the gain of the amplifier comprising the amplifying transistor 1 will be controlled variably.

To use the variable gain amplifier shown in Figs. 1A and 1B for high-frequency amplification, it is essential to ground the emitter of the amplifying transistor 1 in AC mode, which requires the capacitor 8. This amplifier is therefore undesirable for LSI.

When the signal applied to the input terminal 3 has a frequency of 1 GHz, for example, the capacitance of the capacitor 8 should be 170 pF to provide an impedance of about 1 Ω. Thus, the area of the capacitor 8 occupies most of the IC chip area, making the amplifier quite undesirable for LSI.

Because the amplifying transistor 1 and the current-source transistor 71 are connected in series, it is difficult to use a low-voltage power source for the circuit. When a variable gain amplifier is used particularly in a battery-driven electronic device typified by a mobile telephone, the power source voltage must be set low. The conventional amplifier shown in Figs. 1A and 1B has a critical shortcoming for such a usage.

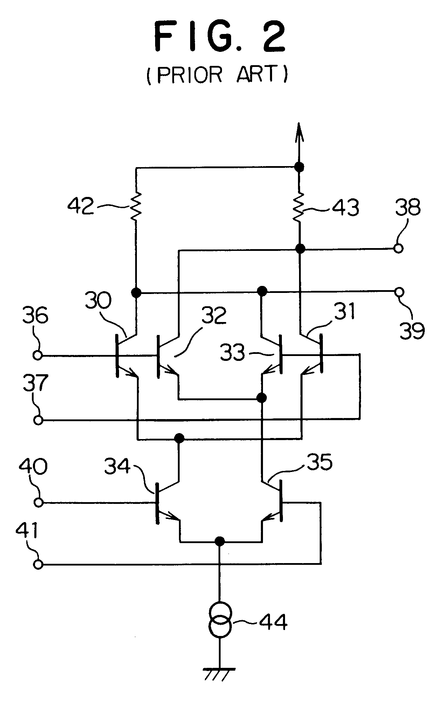

Fig. 2 shows another conventional variable gain amplifier, which is a so-called Gilbert multiplier. This circuit is disclosed in the report entitled "Silicon Bipolar Fixed and Variable Gain Amplifier MMICs For Microwave and Lightwave Applications up to 6 GHz," IEEE MTT-S Digest, '89, pages 109-112.

Differential input terminals 36 and 37 are respectively connected to the bases of a differential pair of transistors 30 and 31, so that differential inputs given to those terminals 36 and 37 are respectively applied to the bases of those transistors 30 and 31. The differential inputs to the differential input terminals 36 and 37 are also applied to the bases of another differential pair of transistors 32 and 33. The collectors of the transistors 30 and 33 are connected together to one of output terminals, 39, while the collectors of the transistors 31 and 32 are connected together to the other output terminal 38. A load resistor 42 is connected between the node between the collectors of the transistors 30 and 33 and the circuit power source, and a load resistor 43 is connected between the node between the collectors of the transistors 31 and 32 and the circuit power source.

The emitters of the differential pair of transistors 30 and 31 are connected together, and a transistor 34, which supplies a current to those emitters, is connected to the emitter node. Likewise, the emitters of the differential pair of transistors 32 and 33 are connected together, and a transistor 35, which supplies a current to those emitters, is connected to the emitter node. Differential input terminals 40 and 41 are respectively connected to the bases of those transistors 34 and 35, permitting differential inputs to be applied to the respective bases. A constant-current source 44 is provided between the emitter node of both transistors 34 and 35 and the ground.

With the above structure, the amplifier gain of the AC signal that is applied to the differential input terminals 40 and 41 can be controlled variably by the control voltage which is applied via the differential input terminals 36 and 37. Conversely, the amplifier gain of the AC signal that is applied to the differential input terminals 36 and 37 can be controlled variably by the control voltage which is applied via the differential input terminals 40 and 41.

As the amplifier shown in Fig. 2 is a differential circuit, it is considerably suitable for LSI. Since the two stages of transistors are connected in series (cascade-connected) between the power sources, however, it is difficult to design this amplifier to be operable on a low voltage. In addition, since this amplifier always operates on the constant current from the constant-current source 44, the amplifier consumes the same current in the case of a low gain as well as in the case of a high gain. It is therefore difficult to reduce a power consumption in this conventional amplifier, and this amplifier, like the conventional amplifier shown in Fig. 1, is unsuitable for use in a portable electronic device.

It is therefore an object of the present invention to provide a variable gain amplifier, which will be operable on a low voltage, will accomplish low power consumption, is easy to be integrated, and is suitable for use in a battery-driven portable electronic device.

A variable gain amplifier according to the present invention comprises; an emitter-grounded type amplifying transistor having a collector from which an amplified output is to be output; and a variable current source, provided between a base of said transistor and a reference potential point, for variably controlling a base bias current of said transistor.

According to the present invention, said variable current source for controlling a change in the base bias of an emitter-grounded type amplifying transistor is provided between the base of said amplifying transistor and a reference potential point (source voltage or ground), thus eliminating the need to control the collector current of said amplifying transistor. This makes the driving power for gain control significantly smaller, and achieves low consumed power.

Further, as it is unnecessary to use a bypass capacitor for grounding an AC signal, this amplifier becomes very suitable for LSI. Furthermore, as it is unnecessary to connect the transistor in series between the power sources, the amplifier can operate on a low voltage and thus becomes very suitable as an amplifier which is driven by the battery of a portable electronic device or the like.

Disclosed is a variable gain amplifier. A variable current source is provided between the base of an emitter-grounded transistor and the ground, so that the distribution of the base bias current of the transistor is controlled by controlling a change in the current of the variable current source , thereby controlling the amplifier gain. As the emitter of the transistor can be directly grounded, thus eliminating the need for a bypass capacitor and facilitating integration of the amplifier. As the base current of the transistor is controlled, the control power can be made very low. Further, a single stage of a transistor is provided between the power source and the ground, the voltage of the power source can be reduced further. It is therefore possible to provide a variable gain amplifier, which accomplishes low power consumption, is operable on a low voltage, is easy to be integrated, and is suitable for use as a high-frequency power amplifier of 1 to 2 GHz in a battery-driven portable electronic device, such as a mobile telephone.
Fig. 1A is a diagram showing the basic structure of a conventional variable gain amplifier, and Fig. 1B is a circuit diagram showing a specific example of the amplifier;
Fig. 2 is a circuit diagram showing another example of the conventional variable gain amplifier;
Fig. 3 is a circuit diagram for explaining one embodiment of this invention;
Fig. 4 is a circuit diagram for explaining another embodiment of this invention;
Fig. 5 is a circuit diagram showing a specific example of the amplifier shown in Fig. 3;
Fig. 6 is a circuit diagram showing another specific example of the amplifier shown in Fig. 3;
Fig. 7 is a graph exemplifying the characteristic of the amplifier shown in Fig. 6; and
Fig. 8 is a circuit diagram showing a specific example of the amplifier shown in Fig. 4.

Preferred embodiments of the present invention will now be described referring to the accompanying drawings. In the diagrams, same reference numerals are given to identical or corresponding elements.

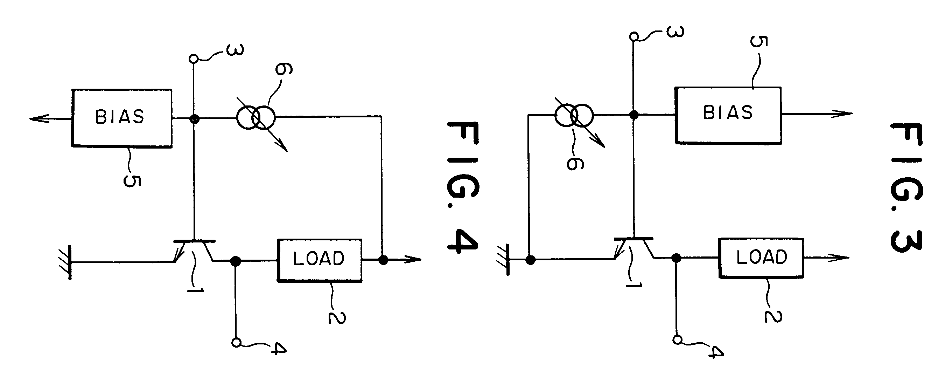

Fig. 3 presents a circuit diagram for explaining the concept of a first embodiment of this invention. An amplification output terminal 4 and a load 2 are connected to the collector of an emitter-grounded amplifying transistor 1. This load 2 permits an amplified output to be extracted from the amplification output terminal 4. A base bias circuit 5 and an input terminal 3 are connected to the base of the transistor 1, with a variable current source 6 connected between this base and the ground to control the base bias current to thereby change the amplifier gain. The emitter of the transistor 1 is grounded.

In the example shown in Fig. 3, the variable current source 6 is provided between the base of the transistor 1 and the ground potential point, so that the distribution of the base bias current of the transistor 1 is controlled by the variable current source 6. More specifically, as the current of the variable current source 6 increases, the base bias current to the transistor 1 from the bias circuit 5 is absorbed more accordingly by the current source 6, resulting in a decrease in base bias current. If the current of the variable current source 6 decreases, on the other hand, the absorption of the base bias current to the transistor 1 from the bias circuit 5 by the current source 6 gets lower, resulting in an increase in base bias current.

As apparent from the above, the distribution of the base bias current to the amplifying transistor 1 is controlled to accomplish gain control by controlling the current of the variable current source 6.

Fig. 4 presents a circuit diagram for explaining the concept of another embodiment of this invention, and same reference numerals as used in Fig. 3 are given to identical or corresponding elements in Fig. 4. In this amplifier, the variable current source 6 is provided between the base of the transistor 1 and the source voltage, and the current of the variable current source 6 is supplied as the base bias current to the transistor 1.

In other words, as the current of the variable current source 6 increases, the base bias current is supplied more to the transistor 1. If the current of the variable current source 6 decreases, on the other hand, the base bias current to the transistor 1 decreases accordingly. It is apparent that the base bias current to be supplied to the amplifying transistor 1 is varied to accomplish gain control by controlling the current of the variable current source 6.

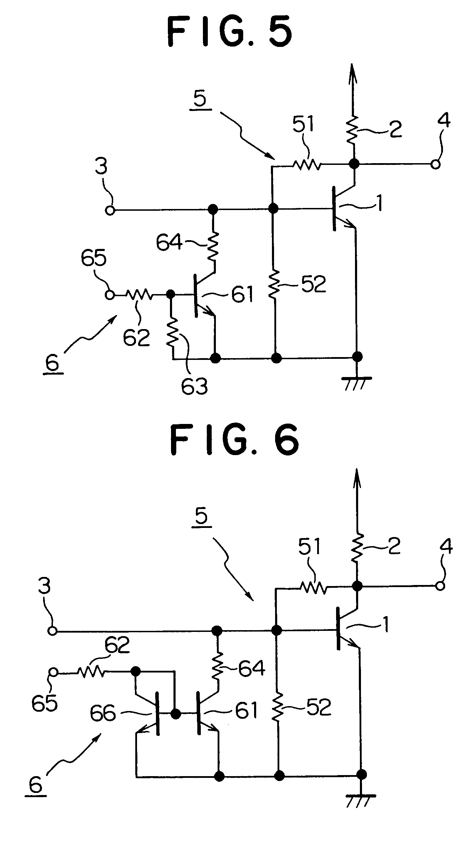

Figs. 5 and 6 present circuit diagrams showing specific examples of the amplifier shown in Fig. 3. In the specific example of Fig. 5, the base bias circuit 5 for the amplifying transistor 1 is of a self-bias type, and has a resistor 51 connected between the collector and base of the transistor 1 and a resistor 52 connected between the base of the transistor 1 and the ground.

The variable current source 6 includes a current-source transistor 61, a collector resistor 64 connected between the collector of the transistor 61 and the base of the transistor 1, a base bias resistor 63 connected between the base of the transistor 61 and the ground, and a base bias resistor 62 connected between a base-input voltage terminal 65 and the base of the transistor 61. By controlling the base input voltage input to the base-input voltage terminal 65 of the transistor 61, the collector current of the transistor 61 changes accordingly. As a result, the distribution of the base bias current of the transistor 1 is controlled.

The specific example shown in Fig. 6 will now be described. The variable current source 6 in this variable gain amplifier is constituted as a current mirror circuit. More specifically, the variable current source 6 in Fig. 6 has a diode-connected transistor 66, additionally provided to the variable current source shown in Fig. 5, and the base bias resistor 63 in Fig. 5 is removed therefrom. The transistor 66 has its base and collector commonly connected to the base of the transistor 61, with its emitter grounded.

With the above structure, by controlling the base input voltage of the transistor 66, which is applied to the base-input voltage terminal 65, via the resistor 62, the mirror current of the current mirror circuit is changed accordingly.

As the variable current source 6 is designed as a current mirror circuit, the relationship between the base input voltage (control voltage) at the input terminal 65 and the current in the transistor 61 (mirror current) becomes nearly linear, which is desirable.

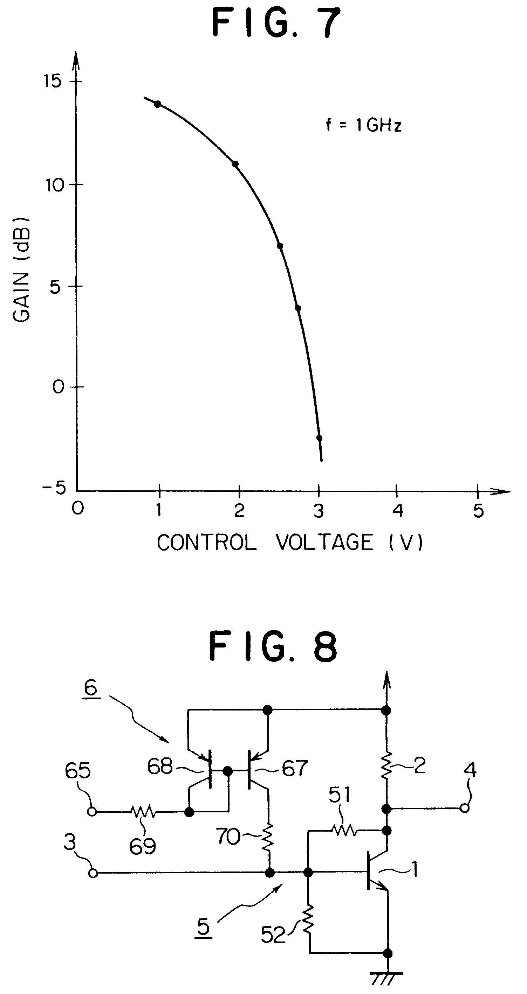

Fig. 7 shows the gain characteristic of the amplifier shown in Fig. 6. The horizontal scale represents a current-mirror control input voltage (V) that is input to the terminal 65, and the vertical scale represents a gain (dB). This graph is for the signal frequency of f = 1 GHz. It is apparent from Fig. 7 that the variable range of the gain is as wide as 20 dB and that the variable gain amplifier of this embodiment is suitable as a high-frequency variable gain amplifier for a mobile telephone or the like.

Fig. 8 presents a circuit diagram showing a specific example of the amplifier shown in Fig. 4. Same reference numerals as used in Figs. 3 to 6 are given to identical or corresponding elements in Fig. 8. In the variable gain amplifier shown in Fig. 8, the variable current source 6 provided between the base of the transistor 1 and the source voltage, like the amplifier in Fig. 6, is designed to have a current-mirror structure, and the control voltage and the mirror current have almost a linear relation with each other.

As shown in Fig. 8, current-mirror transistors 67 and 68 are both PNP transistors. The emitters of the transistors 67 and 68 are both connected to the source voltage, and their bases are connected together. The transistor 68 has its collector and base connected together, with a resistor 69 connected between the collector of the transistor 68 and the control-voltage input terminal 65. A resistor 70 is connected between the collector of the transistor 67 and the base of the transistor 1. This design allows the control voltage input to the control-voltage input terminal 65 to be supplied as a base voltage for the diode-structured transistor 68 via the resistor 69, and permits the mirror current of the transistor 67 to be supplied via the resistor 70 to the base of the transistor 1.

The variable gain amplifiers according to the above-described embodiments are emitter-grounded amplifiers, and the emitter of the amplifying transistor 1 will be directly connected to the ground, which is one reference potential point. This design eliminates the need for a AC-grounding capacitor and facilitates the circuit integration of the amplifier.

Further, it is unnecessary to connect a plurality of transistors in series (cascade connection) between the power source and the ground, allowing the amplifier to be operable on a low voltage. Since the gain control is performed by the base current of the amplifying transistor 1, not the collector current, the driving power of the control voltage at the control-voltage input terminal 65 becomes considerably small. Furthermore, unlike in the multiplier operating system in the conventional amplifier shown in Fig. 2, the collector current need not be bypassed at the time the gain control is executed. Those two advantages contribute to accomplishing lower power consumption.

Although the amplifying transistor 1 is designed as a self-bias type to improve the circuit performance in the above-described embodiments, the same advantages will be obtained employing another bias system, e.g., a fixed bias system.

## Claims

1. A variable gain amplifier characterized by comprising:
an emitter-grounded type amplifying transistor (1) having a collector from which an amplified output is to be output and a base to which an input to be amplified is to be input; and
a variable current source (6), provided between a base of said amplifying transistor and a reference potential point, for variably controlling a base bias current of said amplifying transistor.

2. The variable gain amplifier according to claim 1, characterized in that said reference potential point is a ground potential point.

3. The variable gain amplifier according to claim 2, further comprising
a load (2) connected between a source voltage and a collector of said amplifying transistor (1); and
a base bias circuit (5) connected between said base of said amplifying transistor (1) and said source voltage, wherein said variable current source (6) controls a distribution of a bias current from said base bias circuit to said base of said amplifying transistor.

4. The variable gain amplifier according to claim 2, characterized in that said variable current source (6) comprises:
a current-source transistor (61) connected between said base of said amplifying transistor (1) and said ground potential point; and
control means (62,63,65) for variably controlling a base potential of said current-source transistor.

5. The variable gain amplifier according to claim 2, characterized in that said variable current source (6) comprises:
a current-source transistor (61) connected between said base of said amplifying transistor (1) and said ground potential point;
a diode-connected transistor (66) constituting a current mirror circuit with said current-source transistor (61); and
control means (62,65) for variably controlling a mirror current of said current mirror circuit.

6. The variable gain amplifier according to claim 1, characterized in that said reference potential point is a source voltage point.

7. The variable gain amplifier according to claim 6, characterized in that said variable current source (6) comprises:
a current-source transistor (67) connected between said base of said amplifying transistor (1) and said source voltage point; and
control means (65,69) for variably controlling a base potential of said current-source transistor.

8. The variable gain amplifier according to claim 6, characterized in that said variable current source (6) comprises:
a current-source transistor (67) connected between said base of said amplifying transistor (1) and said source voltage point;
a diode-connected transistor (68) constituting a current mirror circuit with said current-source transistor (67); and
control means (65,69) for variably controlling a mirror current of said current mirror circuit.
